# EUROPÄISCHE PATENTSCHRIFT

(11) **EP 0 417 639 B1**
(45) Veröffentlichungstag und Bekanntmachung des Hinweises auf die Patenterteilung: **17.08.1994**
(21) Anmeldenummer: 90117157.9
(22) Anmeldetag: 06.09.1990
(51) Int. Cl.: H01J 37/067

(54) **Elektronenstrahlerzeuger für eine Elektronenstrahlkanone**
Electron bream producing device for electron gun
Dispositif de production d'un faiceau d'électrons pour canon à électrons

(30) Priorität: 09.09.1989 DE 3930202
(43) Veröffentlichungstag der Anmeldung: 20.03.1991
(73) Patentinhaber: PTR PRÄZISIONSTECHNIK GMBH, 63461 Maintal (DE)
(72) Erfinder: Fritz, Dieter, D-6460 Gelnhausen (DE)
(74) Vertreter: Sartorius, Peter, Dipl.-Ing.

(56) Entgegenhaltungen:
- EP-A- 0 323 898
- DE-A- 3 442 081
- FR-A- 2 114 205
- US-A- 3 187 216
- JOURNAL OF PHYSICS E. SCIENTIFIC INSTRUMENTS. vol. 1, 1968, ISHING, BRISTOL GB Seiten 136 - 139; S J B Reed: "Probe current stability in electron-probe microanalysis"

## Beschreibung

Die Erfindung bezieht sich auf Elektronenstrahlerzeuger für eine Elektronenstrahlkanone gemäß dem Oberbegriff von Anspruch 1, mit eine Kathode, einer Steuerelektrode und einer Anode, die in einer evakuierbaren Beschleunigungskammer angeordnet sind. Solche Elektronenstrahlerzeuger werden zur Metallbearbeitung verwendet. Sie erzeugen einen Elektronenstrahl, der von einer elektromagnetischen Fokussiereinrichtung gebündelt auf ein Werkstück gerichtet wird, um dort beispielsweise Material abzutragen oder zu verschmelzen. Hierbei besteht die Notwendigkeit, den Elektronenstrahl an unterschiedliche Bearbeitungsvorgänge und Materialbeschaffenheiten in seiner Leistung anzupassen, beispielsweise durch Änderung der Beschleunigungsspannung und des Strahlstroms.

Es hat sich jedoch gezeigt, daß die bekannten Elektronenstrahlerzeuger nur in einem eng begrenzten Leistungsbereich optimal betrieben werden. Dieser optimale Leistungsbereich wird definiert durch die Emittanz, dem Produkt aus Fokusradius und Raumwinkel, welche abhängig vom Strahlstrom variiert. Um den gesamten Arbeitsbereich einer Elektronenstrahlkanone optimal nutzen zu können, war es daher seither erforderlich, den Elektronenstrahlerzeuger von Fall zu Fall auszutauschen.

Es ist bei der Kathode einer Elektronenstrahlröhre (FR-A-2 114 205) allgemein bekannt, die Kathode mit einer Emissionsfläche zu versehen, die von einer zylindrisch leitenden Blende umgeben ist, wobei die Zugehörige Fokussierungslinse axial verschiebbar montiert ist. Ein Austausch der einzelnen Teile zur Strahlenanpassung ist mit dieser Anordnung nicht möglich. Das gleiche gilt auch für die Vorrichtung bei einer Kathodenhalterung einer Dispenserkathode (EP-A-323 898), bei der lediglich eine Justierung der einzelnen zur Wehnelt-Elektrode gehörenden Teile möglich ist, während im Anodenhalter in einer kreisförmigen Aussparung eine Anodenplatte auswechselbar aufgenommen ist. Auch hier ist keine Anpassung der Strahlengeometrie möglich.

Der Erfindung liegt die Aufgabe zugrunde, den beschriebenen Nachteil zu beseitigen und einen Elektronenstrahlerzeuger der eingangs genannten Art zu schaffen, der mit einfachen Mitteln innerhalb des Arbeitsbereichs der Elektronenstrahlkanone an den gewählten Leistungsbereich angepaßt werden kann.

Diese Aufgabe wird erfindungsgemäß dadurch gelöst, daß die Steuerelektrode aus einem topfförmigen, hohlzylindrischen Mantelkörper besteht, in dem ein Kathodenkörper und Einsätze auswechselbar aufnehmbar sind, wobei der Mantelkörper einen Boden mit einer konzentrisch zur Mittelachse der Steuerelektrode ausgerichteten Bohrung aufweist, in der ein der Kontur der Mittelbohrung angepaßter Einsatz wahlweise einsetzbar ist, der ebenfalls eine konzentrisch zur Mittelachse der Steuerelektrode ausgerichtete Bohrung aufweist.

Durch den Einbau der einzelnen Teile ist es auf einfache und kostengünstige Weise möglich, eine Anpassung der Strahlengeometrie vorzunehmen, wobei hierzu lediglich die einzelnen Teile in der Steuerelektrode oder Anode ausgewechselt werden müssen, ohne daß dabei an der Außenkontur der Steuerelektrode irgendwelche Änderungen vorzunehmen sind.

Um nunmehr den Leistungsbereich bzw. Arbeitsbereich der Elektronenstrahlröhre optimal zu nutzen bzw. zu variieren, ist es nun nicht mehr notwendig, den gesamten Elektronenstrahlerzeuger durch einen anderen zu ersetzen, da hierzu lediglich die einzelnen Teile ohne weiteres in kürzester Zeit ausgewechselt werden können.

Dieser optimale Leistungsbereich wird durch die Emittanz, dem Produkt aus Focusradius und Raumwinkel, definiert, welche abhängig vom Strahlstrom variiert. Bei Produktionsanlagen wird eine Optimierung für einen spezifischen Einsatz des Elektronenstrahlerzeugers ermöglicht und die Erzielung reproduzierbarer Arbeitsergebnisse erleichtert. Die einzelnen, in den topfförmigen hohlzylindrischen Mantelkörper vorgesehenen und austauschbaren Einsätze sowie der auswechselbare Kathodenkörper sind sehr kostengünstig, da nur wenige Ersatzteile auf Lager gehalten werden müssen und nicht mehr, wie bisher, die gesamte Elektronenstrahlkanone. Hierdurch ist eine wesentliche Kostenreduzierung möglich, und die Elektronenstrahlkanone kann in kürzester Zeit an unterschiedliche Erfordernisse angepaßt werden.

Ferner ist es vorteilhaft, daß die Außenkontur der Elektroden durch Einbau der Kathodenkörper und der Einsätze unverändert bleibt und der Elektrostrahlerzeuger auf kleinste Feldstärke hin optimiert ist.

Durch die vorteilhafte Ausbildung der Elektroden bzw. des topfartigen Mantelkörpers läßt sich eine Umrüstung der Elektroden auch dann vornehmen, wenn unterschiedliche Einsätze im Mantelkörper vorgesehen werden, ohne daß dabei die Außenkontur der Elektroden verändert wird. Diese Auslegung führt auch zu einer hohen Betriebssicherheit und ermöglicht eine universelle Adaption des Elektronenstrahlerzeugers durch Variation der Wechselteile.

Eine zusätzliche Möglichkeit ist gemäß einer Weiterbildung der erfindungsgemäßen Vorrichtung, daß der der Kontur der Mittelbohrung angepaßte Einsatz aus einem hochpermeablen Material besteht und daß der in den Mantelkörper einsetzbare Kathodenhalter von einem Isolator getragen wird.

Gemäß einer bevorzugten Ausführungsform der erfindungsgemäßen Lösung ist schließlich vorgesehen, daß die als Wechselteil ausgebildete Anode aus einer auswechselbaren Anodenhülse und einem auswechselbaren Distanzring gebildet ist, durch den der Anodenabstand veränderbar ist und daß in Strahlrichtung hinter der Anode eine als Wechselteil ausgebildete, ringförmige Blende vorgesehen ist.

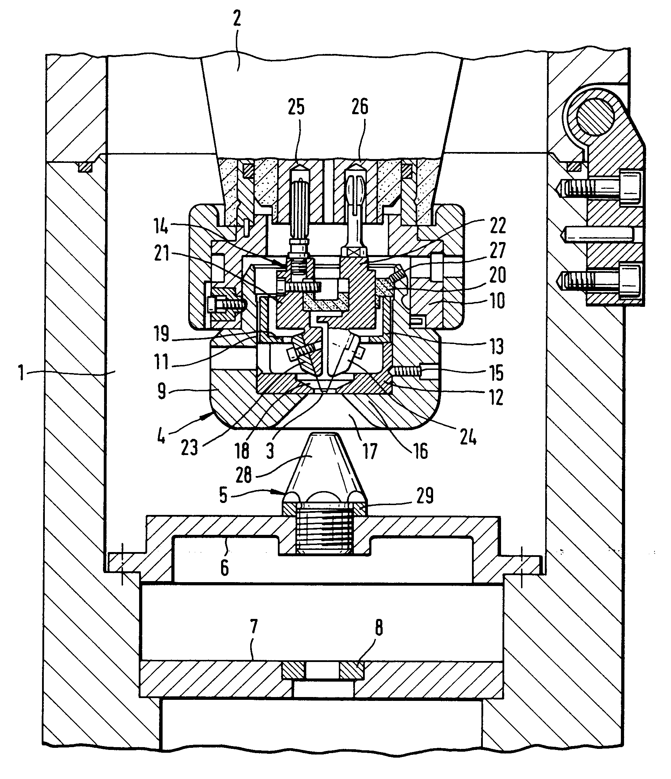

Anhand eines in der Zeichnung dargestellten Ausführungsbeispiels wird die Erfindung im folgenden näher erläutert. Die Zeichnung zeigt einen Längsschnitt des erfindungsgemäßen Elektronenstrahlerzeugers.

Bei dem dargestellten Elektronenstrahlerzeuger sind im Zentrum einer evakuierbaren Beschleunigungskammer 1 an einem Isolator 2 eine Kathode 3 und eine Steuerelektrode 4 angeordnet, die über elektrische Anschlußleitungen im Innern des Isolators 2 an einen Hochspannungserzeuger anschließbar sind. In einem Abstand von der Kathode 3 befindet sich coaxial zu dieser eine ringförmige Anode 5, die von einer Platte 6 getragen wird und mit der Beschleunigungskammer 1 auf Erdpotential liegt. In einer zweiten Platte 7 ist im Abstand von der Anode 5 eine Blende 8 vorgesehen.

Die Steuerelektrode 4 weist einen topfförmigen, zylindrischen Mantelkörper 9 auf, dessen Außenkontur zur Erzielung minimaler Feldstärken optimiert wurde. Der Mantelkörper 9 wird von einem Befestigungsflansch 10 getragen, an dem er leicht lösbar mit einer Rastverbindung gehalten ist. In einer zentralen, zylindrischen Bohrung 11 des Mantelkörpers 9 befinden sich übereinander ein Einsatz 12, ein Stützring 13 und ein Kathodenhalter 14, die sich aneinander abstützen und dadurch eine genaue räumliche Zuordnung zueinander haben. Der Einsatz 12 hat die Form eines zylindrischen Topfes und ist mit seiner zylindrischen Mantelfläche in der Bohrung 11 des Mantelkörpers 9 zentriert. Durch die Klemmschraube 15, die in eine Nut eingreift, wird der Einsatz 12 in der Bohrung 11 arretiert, wobei er an dem Boden 16 des Mantelkörpers 9 anliegt. Im Boden 16 ist eine sich in Strahlrichtung keglig erweiternde Mittelbohrung 17 für den Durchtritt des Elektronenstrahls vorgesehen. An die Mittelbohrung 17 schließt sich eine Öffnung 18 im Einsatz 12 an, die im Durchmesser kleiner bemessen ist und die den Emissionsbereich der Kathode 3 umgibt. Die Öffnung 18 ist zum Kathodenhalter 14 hin keglig erweitert. In ihrem Durchmesser und in ihrer Form ist die Öffnung 18 an eine für einen bestimmten Leistungsbereich geeignete Kathodengröße angepaßt. Wird für einen anderen Leistungsbereich eine Kathode anderer Größe eingebaut, so wird auch der Einsatz 12 gegen einen zu dieser anderen Kathode passenden ausgetauscht.

Der Stützring 13 umgibt den Kathodenhalter 14 und sorgt für dessen genaue axiale Positionierung zum Einsatz 12 der Steuerelektrode 4. Mit einem radial nach innen gerichteten Kragen 19 wird von dem Stützring 13 ein Isolator 20 des Kathodenhalters 14 optisch gegenüber dem Elektronenstrahl abgedeckt. Der Kathodenhalter 14 hat zwei im wesentlichen spiegelbildlich ausgebildete Anschlußklemmen 21, 22, die in dem Isolator 20 gehalten sind und an ihren unteren Enden Klemmschuhe 23, 24 zum Befestigen der beiden Enden der Kathode 4 tragen. Über Steckkontakte 25, 26 sind die Anschlußklemmen 21, 22 an den Heizstromkreis des Elektronenstrahlerzeugers angeschlossen. Ebenso wie der Einsatz 12 und der Stützring 13 bildet der Kathodenhalter 14 ein Wechselteil, welches passend für verschiedene Kathodengrößen vorgesehen ist. Mit einer Klemmschraube 27 ist der Kathodenhalter 14 im Mantelkörper 9 befestigt.

Die Anode 5 weist eine auswechselbare Anodenhülse 28 auf, die mit einem Gewindestutzen in eine Gewindebohrung in der Platte 6 eingeschraubt ist. Die Anodenhülse 28 sowie der Anodendistanzring 29 sind Wechselteile. Zur Optimierung des Elektronenstrahls für einen bestimmten Leistungsbereich kann daher aus einer Mehrzahl von Anodenhülsen 28 mit unterschiedlichem Bohrungsdurchmesser die jeweils geeignete ausgewählt und mit einem Anodendistanzring 29 die Beschleunigungslänge optimiert werden. Weiterhin können in die Platte 7 Blenden 8 mit unterschiedlichhem Durchmesser eingesetzt werden, um die gewünschte Strahlqualität zu erreichen.

Um den Elektronenstrahlerzeuger für einen bestimmten Einsatz einzurichten, wird das Gehäuse der Beschleunigungskammer 1 aufgeklappt, wodurch die Elektroden gut zugänglich werden. Zum Einrichten der Kathode 3 und Steuerelektrode 4 kann der Mantelkörper 9 vom Befestigungsflansch 10 abgenommen und mit einem Einsatz 12, einem Stützring 13 und einem Kathodenhalter 14 mit einer Kathode 4 in der gewünschten Größe bestückt werden. Gleichzeitig können die passende Anodenhülse 28, der Anodendistanzring 29 und die Blende 8 eingebaut werden. Diese Maßnahmen sind einfach und schnell durchführbar und nur mit geringen Teilkosten verbunden. Es wird somit auf einfache und kostengünstige Weise eine optimale Anpassung des Elektronenstrahlerzeugers an den jeweiligen Einsatzfall ermöglicht.

## Patentansprüche

1. Elektronenstrahlerzeuger für eine Elektronenstrahlkanone, mit einer Kathode (3), einer Steuerelektrode (4) und einer Anode ((5), die in einer evakuierbaren Beschleunigungskammer (1) angeordnet sind, wobei zumindest die Steuerelektrode (4) und Anode (5) auswechselbare Teile (29) aufweist, **dadurch gekennzeichnet, daß** die Steuerelektrode (4) aus einem topfförmigen, hohlzylindrischen Mantelkörper (9) besteht, in dem ein Kathodenkörper (14) und Einsätze ((12,13) auswechselbar aufnehmbar sind, wobei der Mantelkörper (9) einen Boden (16) mit einer konzentrisch zur Mittelachse der Steuerelektrode (4) ausgerichteten Bohrung (17) aufweist, in der ein der Kontur der Mittelbohrung (17) angepaßter Einsatz (12) wahlweise einsetzbar ist, der ebenfalls eine konzentrisch zur Mittelachse der Steuerelektrode (4) ausgerichtete Bohrung (17) aufweist.

2. Elektronenstrahlerzeuger nach Anspruch 1, **dadurch gekennzeichnet, daß** die Außenkontur der Elektroden (3, 4, 5) durch Einbau der Kathodenkörper (14) und der Einsätze ((12,13) unverändert bleibt und der Elektronenstrahlerzeuger auf kleinste Feldstärke hin optimiert ist.

3. Elektronenstrahlerzeuger nach Anspruch 1, **dadurch gekennzeichnet, daß** der der Kontur der Mittelbohrung (17) angepaßte Einsatz (12) aus einem hochpermeablen Material besteht.

4. Elektronenstrahlerzeuger nach einem der Ansprüche 1 oder 3, **dadurch gekennzeichnet, daß** der in den Mantelkörper (9) einsetzbare Kathodenhalter (14) von einem Isolator (20) getragen wird.

5. Elektronenstrahlerzeuger nach Anspruch 1, **dadurch gekennzeichnet, daß** die als Wechselteil ausgebildete Anode (5) aus einer auswechselbaren Anodenhülse (28) und einem auswechselbaren Distanzring (29) gebildet ist, durch den der Anodenabstand veränderbar ist.

6. Elektronenstrahlerzeuger nach einem der vorhergehenden Ansprüche, **dadurch gekennzeichnet, daß** in Strahlrichtung hinter der Anode (5) eine als Wechselteil ausgebildete, ringförmige Blende (8) vorgesehen ist.

## Claims

1. Electron beam generator for an electron beam gun, having a cathode (3), a control electrode (4) and an anode (5), which are arranged in an evacuable accelerating chamber (1), whereby at least the control electrode (4) and the anode (5) have interchangeable parts (29), characterized in that the control electrode (4) consists of a pot-shaped, hollow cylindrical jacket (9) in which a cathode (14) and inserts (12, 13) can be installed interchangeably, whereby the jacket (9) has a bottom (16) with a bore (17) oriented concentrically to the middle axis of the control electrode (4) into which bore an insert (12) adapted to the shape of the central bore (17) can be inserted interchangeably, which likewise has a bore (17) oriented concentrically to the middle axis of the control electrode (4).

2. Electron beam generator according to Claim 1, characterized in that the external shape of the electrodes (3, 4, 5) remains unchanged by the installation of the cathodes (14) and inserts (12, 13) and in that the electron beam generator is optimized for minimum field strength.

3. Electron beam generator according to Claim 1, characterized in that the insert (12) adapted to the shape of the middle bore (17) consists of a highly permeable material.

4. Electron beam generator according to either of Claims 1 or 3, characterized in that the cathode holder (14) which can be installed in the jacket (9) is borne by an insulator (20).

5. Electron beam generator according to Claim 1, characterized in that the anode (5), which is designed as an interchangeable part, consists of an interchangeable anode sleeve (28) and an interchangeable spacing ring (29), with which the anode distance can be changed.

6. Electron beam generator according to any one of the foregoing claims, characterized in that, in the beam direction behind the anode (5), there is an annular diaphragm (8) in the form of an interchangeable part.

## Revendications

1. Générateur de rayons électroniques pour un canon à électrons comportant une cathode (3), une électrode de commande (4) et une anode (5) disposées dans une chambre d'accélération (1) pouvant être mise sous vide et dans lequel au moins l'électrode de commande (4) et l'anode (5) présentent des pièces échangeables (29), **caractérisé en ce que** l'électrode de commande (4) est constituée par un corps cylindrique creux (9) ayant la forme d'un pot qui accepte un corps de cathode (14) et des inserts (12, 13) échangeables, ledit corps cylindrique creux (9) présentant un fond (16) avec un alésage (17) orienté de façon concentrique par rapport à l'axe central de l'électrode de commande (4), dans lequel un insert (12) dont le contour est adapté à celui de l'alésage central (17) peut être inséré au choix, ledit insert présentant lui aussi un alésage (17) orienté de façon concentrique par rapport à l'axe central de l'électrode de commande (4).

2. Générateur de rayons électroniques suivant la revendication 1, **caractérisé en ce que** le contour extérieur des électrodes (3, 4, 5) n'est pas modifié par le montage des corps de cathode (14) et des inserts (12, 13) et que le générateur de rayons électroniques est conçu pour la plus petite intensité de champ possible.

3. Générateur de rayons électroniques suivant la revendication 1, **caractérisé en ce que** l'insert (12) adapté au contour de l'alésage central (17) consiste en un matériau très perméable.

4. Générateur de rayons électroniques suivant l'une quelconque des revendications 1 ou 3, **caractérisé en ce que** le porte-cathode (14) pouvant être inséré dans le corps cylindrique creux (9) est supporté par un isolateur (20).

5. Générateur de rayons électroniques suivant la revendication 1, **caractérisé en ce que** l'anode (5) conçue en tant que pièce échangeable, est constituée par une douille d'anode échangeable (28) et par une bague d'écartement échangeable (29) permettant de varier la distance de l'anode.

6. Générateur de rayons électroniques suivant l'une quelconque des revendications 1 à 5, **caractérisé en ce qu**'un diaphragme annulaire (8) conçu en tant que pièce échangeable est prévu en aval de l'anode (5) en direction du faisceau.
